# DEMANDE DE BREVET EUROPEEN

(11) **EP 4 768 426 A1**
(43) Date de publication de la demande: **01.07.2026**
(21) Numéro de dépôt: 25224223.5
(22) Date de dépôt: 17.12.2025
(51) Int. Cl.: B81B 7/00

(54) **PROCÉDÉ DE REPORT D'UN MEMS SUR UN SUBSTRAT**

(30) Priorité: 19.12.2024 FR 2414730
(71) Demandeur: EXAIL, 78100 Saint-Germain-en-Laye (FR)
(72) Inventeur: CHEINEY, Pierrick, 78100 SAINT-GERMAIN-EN-LAYE (FR); KERRIEN, Thomas, 78100 SAINT-GERMAIN-EN-LAYE (FR); ROLAND, Iannis, 78100 SAINT-GERMAIN-EN-LAYE (FR); AUBRY, Karl, 78100 SAINT-GERMAIN-EN-LAYE (FR)
(74) Mandataire: Jacobacci & Partners France

(57) **Abrégé**

L'invention concerne un procédé de report d'un MEMS sur un substrat.

Lors du procédé de report, un plot intermédiaire d'absorption vibratoire (10) est interposé entre le MEMS (20) et le substrat (8). Le plot intermédiaire d'absorption vibratoire (10) présente une hauteur minimum telle que la distance entre le MEMS (20) et le substrat (8) est supérieure à 100 µm. De façon avantageuse, les dimensions du plot intermédiaire d'absorption vibratoire (10) sont choisies dans le but d'absorber plus efficacement les vibrations mécaniques du substrat. Le procédé de report selon l'invention permet ainsi d'accroître la précision du MEMS tout en limitant son risque de détérioration, voire de casse, en particulier lorsque ledit MEMS est soumis à un environnement vibratoire de quelques milliers de Hertz.

## Description

### Domaine technique auquel se rapporte l'invention

La présente invention concerne le domaine technique de la microélectronique et, plus particulièrement, un procédé de report d'un MEMS sur un substrat.

### Arrière-plan technologique

L'utilisation des systèmes micro-électromécaniques, dénommés ci-après par l'acronyme anglais MEMS pour « Micro Electro-Mechanical System », est devenue courante dans de nombreuses et diverses industries.

Dans l'industrie automobile, les MEMS sont par exemple employés pour détecter un changement soudain de l'allure d'un véhicule automobile, afin de déclencher lors d'une collision des systèmes de sécurité.

Dans le domaine de l'aérospatiale, les MEMS sont employés pour suivre en temps réel l'orientation ainsi que la vitesse de déplacement d'aéronefs, afin de permettre par exemple son guidage par un système de navigation embarqué.

Les MEMS mentionnés ci-dessus ont la particularité de comprendre des composants mobiles pour réaliser les mesures mentionnées ci-dessus.

Afin de préserver l'intégrité des MEMS et faciliter leur intégration dans des dispositifs électroniques, ceux-ci sont préalablement placés dans des contenants scellés avant leur utilisation. Lors de cette étape dite d'encapsulation, les MEMS sont maintenus au fond d'un contenant par l'intermédiaire de points de colle, puis le contenant est scellé afin de maintenir une atmosphère contrôlée autour du MEMS. On obtient ainsi un module MEMS ou « packaged MEMS » en anglais, apte à être intégré dans des systèmes plus larges. Ces systèmes plus larges peuvent inclure des dispositifs électroniques, des circuits intégrés et d'autres composants nécessaires pour assurer le bon fonctionnement ainsi que la communication des MEMS avec leur environnement.

La précision des mesures réalisées par les MEMS est due en grande partie à l'emploi de parties dites sensibles, telles que des poutres vibrantes ou des masses d'épreuves. Ces parties sensibles réagissent aux changements physiques de leur environnement, transformant ces changements en signaux mesurables. Par exemple, les poutres vibrantes oscillent à une fréquence spécifique qui change en fonction des forces appliquées, permettant ainsi de détecter des accélérations ou des rotations. Les masses d'épreuves, quant à elles, se déplacent en réponse aux mouvements du MEMS, et leur position relative peut être mesurée avec une grande précision pour déterminer l'orientation ou l'accélération d'un dispositif comprenant le MEMS. La sensibilité de ces composants aux moindres variations les rend particulièrement efficaces pour des mesures de haute précision, mais les rend également vulnérables aux perturbations parasites.

Ces perturbations parasites comprennent notamment les vibrations mécaniques transmises au MEMS par le contenant dans lequel ils sont scellés. Ces vibrations mécaniques se propagent alors jusqu'aux parties sensibles du MEMS, faussant les mesures réalisées par le MEMS, empêchant la détection de signaux de faible intensité ou bien pire, entraînant une détérioration prématurée et irréversible desdites parties sensibles.

Afin d'accroître les performances ainsi que la durée de vie des MEMS, il est donc souhaitable d'atténuer ce phénomène de propagation des perturbations parasites au MEMS .

Pour parvenir à cet objectif, il est connu l'emploi de cadres dits de découplage. Ces cadres de découplage sont intercalés entre les MEMS et leur substrat afin d'atténuer ce phénomène de transmission des perturbations parasites entre les MEMS et leur substrat.

Néanmoins, les cadres de découplage ont pour inconvénient d'avoir leurs propres modes de résonance mécanique, typiquement quelques kiloHertz, par exemple de l'ordre de 2.6 kHz. Une vibration extérieure à la fréquence de vibration d'un mode mécanique propre à un cadre de découplage peut alors être amplifiée par ledit cadre de découplage. Ce phénomène d'amplification peut correspondre au facteur de qualité du mode mécanique en question, pouvant aller jusqu'à des amplifications de quelques milliers.

L'invention vise à proposer une solution permettant de limiter le risque de détérioration, voire de casse de la partie sensible d'un MEMS, dû à la transmission de vibrations mécaniques entre ledit MEMS et son substrat, notamment lorsque les vibrations mécaniques sont de l'ordre de quelques milliers de Hertz.

### Objet de l'invention

Afin de parvenir à l'objectif mentionné ci-dessus, l'invention propose un procédé de report d'un MEMS sur un substrat, dans lequel le MEMS est fixé sur le substrat.

L'invention est remarquable en ce qu'un plot intermédiaire d'absorption vibratoire est interposé entre le MEMS et le substrat, et en ce que le plot intermédiaire d'absorption vibratoire présente une hauteur minimum telle que la distance entre le MEMS et le substrat est supérieure à 100 µm.

De façon avantageuse, lorsque le plot intermédiaire d'absorption vibratoire maintient une distance supérieure à 100 µm, entre le MEMS et le substrat, les vibrations mécaniques du substrat et/ou les vibrations mécaniques du MEMS sont absorbées plus efficacement par le plot intermédiaire d'absorption vibratoire, en particulier lorsque les fréquences des vibrations mécaniques sont de l'ordre de quelques milliers de Hertz.

Le procédé de report proposé par l'invention permet ainsi de limiter le risque de détérioration ou de casse du MEMS, lorsque le MEMS est maintenu à un substrat vibrant à des fréquences de l'ordre de quelques milliers de Hertz.

Selon un autre avantage, en absorbant les vibrations du substrat et/ou les vibrations du MEMS, le plot intermédiaire d'absorption vibratoire limite de façon significative l'influence de ces vibrations sur le fonctionnement du MEMS. Le MEMS est ainsi apte à réaliser des mesures de meilleures qualités dans des plages de fréquences de l'ordre de quelques milliers de Hertz. En d'autres termes, les vibrations mécaniques du substrat et/ou les vibrations mécaniques du MEMS sont moins susceptibles de fausser ou bien de dégrader la sensibilité du MEMS dans des plages de modes de résonance propre au MEMS .

Par « mode de résonance propre au MEMS », on entend une ou plusieurs fréquences pour lesquelles au moins une partie sensible d'un MEMS, comprenant par exemple un élément mobile et/ou un élément oscillant, est apte à vibrer et éventuellement entrer en résonance.

Le procédé de report décrit ci-dessus permet ainsi d'accroître les performances du MEMS ainsi que sa longévité.

Selon un autre mode de réalisation de l'invention, le plot intermédiaire d'absorption vibratoire présente une hauteur minimum telle que la distance entre le MEMS et le substrat est supérieur à 200 µm, de préférence comprise entre 250 µm et 500 µm ou de l'ordre de 275 µm.

Selon un autre mode de réalisation de l'invention, le plot intermédiaire d'absorption vibratoire présente une première face en regard du substrat et une deuxième face en regard du MEMS, la plus petite dimension de chacune de ces deux faces est égale ou supérieure à 300 µm, de préférence comprise entre 400 µm et 600 µm ou de l'ordre de 500 µm.

De façon avantageuse, un plot intermédiaire d'absorption vibratoire présentant une hauteur minimum ainsi qu'une plus petite dimension au niveau de sa première et sa deuxième face, sélectionnées dans les plages de valeurs mentionnées ci-dessus, permet une meilleure absorption des vibrations mécaniques du substrat lorsque lesdites vibrations sont comprises dans une plage de fréquences allant de 1 000 Hz à 10 000 Hz, de préférence de 2 500 Hz à 2 700 Hz ou bien de l'ordre de 2 600 Hz.

Selon un autre mode de réalisation de l'invention, la première face et/ou la deuxième face du plot intermédiaire d'absorption vibratoire présente un contour de forme circulaire ou sensiblement circulaire. Un plot intermédiaire d'absorption présentant cette forme offre l'avantage d'être réalisable par des méthodes plus aisées à mettre en œuvre et donc plus économiques.

Selon un mode de réalisation préféré, le plot a une forme prismatique ou cylindrique. Ces formes ont pour avantage d'être plus aisément et rapidement réalisables par la mise en œuvre d'un procédé de découpe d'une couche, tel que décrit ci-dessous, par la mise en œuvre d'un procédé de poinçonnage.

Selon un autre mode de réalisation de l'invention, le procédé de report met en œuvre les étapes suivantes:
a) dépôt d'une première couche de matière adhésive sur le substrat ; puis
b) dépôt du plot intermédiaire d'absorption vibratoire sur la première couche de matière adhésive, la première face du plot intermédiaire d'absorption vibratoire venant en contact avec ladite première couche ; puis
c) dépôt d'une deuxième couche de matière adhésive sur la deuxième face du plot intermédiaire d'absorption vibratoire ; puis
d) mise en contact du MEMS avec la deuxième couche de matière adhésive.

Selon un autre avantage de l'invention, le procédé de report permet de maintenir un MEMS à une plus grande distance de son substrat, en employant une quantité moindre de matière adhésive. En effet, contrairement aux procédés de report connus de l'état de la technique, la matière adhésive n'est pas employée dans le but de maintenir à distance le MEMS de son substrat, mais pour maintenir un plot intermédiaire d'absorption vibratoire entre le MEMS et son substrat. De ce fait, l'épaisseur et donc la quantité de matière adhésive utilisée lors du procédé de report, est nettement moindre par rapport aux procédés de report proposés par l'état de la technique.

Selon un autre avantage, l'emploi d'une quantité de matière adhésive moins importante, réduit de façon significative le temps et/ou la température d'un traitement thermique mit en œuvre après le procédé de report, par exemple lors d'une étape e), pour permettre une polymérisation satisfaisante des couches de matière adhésive, maintenant le plot intermédiaire d'absorption vibratoire entre le MEMS et son substrat. L'invention permet ainsi une économie de temps et de moyens lors du report d'un MEMS sur un substrat.

Selon un autre avantage, lors de la mise en œuvre d'un traitement thermique, après le procédé de report, le phénomène de dégazage des couches de matière adhésive est nettement réduit du fait d'une moindre quantité de matière adhésive employée, comme mentionné ci-dessus. Les risques de dissipation des composés de la matière adhésive dans l'environnement sont alors significativement réduits. En limitant ce phénomène de dégazage, l'invention permet aussi de réduire la présence à la surface du MEMS, de composés issus de la matière adhésive employées pour son maintien sur un substrat, susceptibles de dégrader ou bien d'empêcher le fonctionnement du MEMS.

De préférence, l'épaisseur de la première couche et/ou l'épaisseur de la deuxième couche de matière adhésive, est égale ou inférieure à 20 µm, de préférence comprise entre 1 µm et 10 µm.

La première couche de matière adhésive peut être composée d'un polymère synthétique comprenant du silicium, de préférence, la première couche de matière adhésive est à base de silicone. La deuxième couche de matière adhésive peut être identique ou sensiblement identique à la première couche de matière adhésive.

Selon un autre mode de réalisation de l'invention, le MEMS peut être maintenu au substrat par l'intermédiaire de plusieurs plots intermédiaires d'absorption vibratoire, interposés ou intercalés entre le substrat et le MEMS. Les plots intermédiaires d'absorption vibratoire ont les mêmes caractéristiques ou sensiblement les mêmes caractéristiques que le plot intermédiaire d'absorption vibratoire décrit ci-dessus.

En d'autres termes, les étapes a) à c) du procédé de report décrit ci-dessus, permettant l'interposition d'un plot intermédiaire d'absorption vibratoire entre le substrat et le MEMS, peuvent être reproduites afin que plusieurs plots intermédiaires d'absorption vibratoire soient présents entre le MEMS et le substrat.

Selon un autre mode de réalisation de l'invention, un plot intermédiaire d'absorption vibratoire selon l'invention, est choisi de sorte que la plus petite distance entre la première face et la deuxième face dudit plot est égale ou supérieure à 100 µm, égale ou supérieure à 200 µm, ou de préférence comprise entre 250 µm et 500 µm ou bien de l'ordre de 275 µm.

Selon un autre mode de réalisation de l'invention, le plot intermédiaire d'absorption vibratoire a un facteur de forme compris entre 0,2 et 1, de préférence entre 0,3 et 0,7. Par « facteur de forme », on entend le résultat d'un rapport entre la valeur de la hauteur minimum du plot intermédiaire d'absorption vibratoire, correspondant à la plus petite distance entre sa première face et sa deuxième face, et la valeur de la plus grande dimension de la première face. De préférence, on optera pour un facteur de forme de valeur élevé lorsqu'on souhaite une atténuation accrue d'au moins un mode de résonance propre au MEMS.

Selon un autre mode de réalisation de l'invention, la deuxième face du plot intermédiaire d'absorption vibratoire est parallèle ou sensiblement parallèle à sa première face. Ce mode de réalisation permet avantageusement l'emploi, par exemple, d'une débouchure issue d'un procédé de poinçonnage d'une couche, comme plot intermédiaire d'absorption vibratoire.

Selon un autre mode de réalisation de l'invention, la valeur du module de Young du plot intermédiaire d'absorption vibratoire est comprise 5MPa et 10 MPa, de préférence entre 6 MPa et 9 MPa.

Selon un autre mode de réalisation de l'invention, le plot intermédiaire d'absorption vibratoire est issu d'un procédé de poinçonnage.

De préférence, le plot intermédiaire d'absorption vibratoire est issu d'un procédé de poinçonnage ou de découpe à l'emporte-pièce. Ce type de procédé offre l'avantage de permettre l'obtention de plots intermédiaires d'absorption vibratoire dont la forme et les dimensions sont maîtrisées, de façon nettement plus précise par rapport à une couche de matière adhésive polymérisée.

Selon un autre avantage, la réalisation d'un plot intermédiaire d'absorption vibratoire par un procédé de poinçonnage, permet l'obtention de plot ayant un rapport d'aspect non permis par un dépôt de matière adhésive sur un substrat. En d'autres termes, un procédé de poinçonnage permet la réalisation de plots intermédiaires d'absorption vibratoire présentant une hauteur et une largeur qui n'est pas possible d'obtenir par le dépôt d'une matière adhésive sur un substrat. De ce fait, les plots obtenus par cette méthode présentent des propriétés d'absorption différentes par rapport aux couches de matière adhésive employées pour maintenir un MEMS sur un substrat. La réalisation de plots intermédiaires d'absorption vibratoire par un procédé de poinçonnage, permet donc la réalisation de plot aux dimensions mentionnées ci-dessus, présentant l'avantage d'offrir une meilleure atténuation du stress thermomécanique et une plus grande diminution du facteur de qualité de modes de résonance basse fréquence, notamment dans les plages de fréquences mentionnées ci-dessus.

Selon un autre avantage, la réalisation de plots intermédiaires d'absorption vibratoire par poinçonnage ou découpe à l'emporte-pièce d'une couche, permet l'obtention de plots de façon plus rapide, plus simple et selon une très bonne reproductibilité. La réalisation d'un ou de plusieurs plots intermédiaires d'absorption vibratoire par un procédé de poinçonnage permet également d'automatiser, et donc de réduire de façon significative les coûts, d'un procédé de report décrit ci-dessus.

Selon un autre avantage, le poinçonnage permet la réalisation de plots intermédiaires d'absorption vibratoire, à partir de matrices moins susceptibles de polluer le MEMS, lors par exemple d'un phénomène de dégazage décrit ci-dessus.

Selon un autre mode de réalisation de l'invention, le plot intermédiaire d'absorption vibratoire est composé d'un polymère synthétique comprenant du silicium, de préférence ledit plot est à base de silicone.

Selon un autre mode de réalisation de l'invention, le MEMS est un MEMS résonant ou un MEMS capacitif. Par « MEMS résonant », on entend un MEMS comprenant au moins un élément apte à osciller, dont les fréquences d'oscillation sont mesurées pour caractériser un phénomène physique. À titre d'exemple non limitatif, un MEMS résonant est apte à effectuer les mesures suivantes : accélération, rotation détection de masse...

Bien entendu, les différentes caractéristiques, variantes et formes de réalisation mentionnées ci-dessus peuvent être associées les unes avec les autres, selon diverses combinaisons, dans la mesure où elles ne sont pas incompatibles ou exclusives entre elles.

L'invention concerne également un procédé d'encapsulation d'un MEMS mettant en oeuvre un procédé de report décrit ci-dessus.

À titre d'exemple non limitatif, après la réalisation d'un procédé de report décrit ci-dessus, le procédé d'encapsulation peut mettre en œuvre une étape de positionnement d'un boîtier creux sur le substrat, de sorte que le MEMS maintenu au substrat par l'intermédiaire d'au moins un plot intermédiaire d'absorption vibratoire, soit protégé de l'environnement extérieur par ledit boîtier.

Selon une variante de réalisation, le procédé d'encapsulation peut mettre en œuvre un procédé de report selon l'invention, d'un MEMS dans un boîtier, puis une étape de scellement dudit boîtier par un couvercle, de sorte que le MEMS soit isolé de l'environnement extérieur au boîtier.

Selon un mode de réalisation préféré, à l'issue d'un procédé d'encapsulation décrit ci-dessus, on obtient un module MEMS, comprenant un MEMS dans un boîtier étanche et/ou hermétique.

L'invention concerne également un module MEMS comprenant au moins un MEMS encapsulé dans un boîtier et fixé à un substrat. Le module MEMS est remarquable en ce qu'il comporte au moins un plot intermédiaire d'absorption vibratoire, interposé entre le MEMS et le substrat.

Selon un autre mode de réalisation de l'invention, au moins un plot intermédiaire d'absorption vibratoire présente une hauteur minimum telle que la distance entre le MEMS et le substrat, est supérieure à 100 µm. Pour les raisons mentionnées ci-dessus, de préférence, au moins un plot intermédiaire d'absorption vibratoire présente une hauteur minimum égale ou supérieure à 200 µm, de préférence comprise entre 250 µm et 500 µm ou de l'ordre de 275 µm.

Selon un autre mode de réalisation de l'invention, au moins un plot intermédiaire d'absorption vibratoire présente une première face en regard du substrat et une deuxième face en regard du MEMS. La plus petite dimension de la première face peut être égale ou supérieure à 300 µm, de préférence comprise entre 400 µm et 600 µm. La plus petite dimension de la deuxième face peut être égale ou supérieure à 300 µm, de préférence comprise entre 400 µm et 600 µm.

Selon un autre mode de réalisation de l'invention, une première couche de matière adhésive est présente entre le substrat et ledit au moins un plot intermédiaire d'absorption vibratoire.

Selon un autre mode de réalisation de l'invention, une deuxième couche de matière adhésive est présente entre au moins un plot intermédiaire d'absorption vibratoire et le MEMS.

De préférence, la valeur du module de Young d'au moins un plot intermédiaire d'absorption vibratoire, est comprise entre 5 MPa et 10 MPa, de préférence entre 6 MPa et 9 MPa.

Selon un autre mode de réalisation de l'invention, une paroi du module MEMS est formée par le substrat.

De préférence, un ou plusieurs plots intermédiaires d'absorption vibratoire présents entre le substrat et le MEMS, sont identiques ou sensiblement identiques au plot intermédiaire d'absorption vibratoire employé lors de la mise en œuvre d'un procédé de report décrit ci-dessus.

Selon un autre mode de réalisation, la valeur du module de Young d'au moins un plot intermédiaire d'absorption vibratoire, est comprise entre 5 MPa et 10 MPa, de préférence entre 6 MPa et 9 MPa.

Selon un autre mode de réalisation, au moins un plot intermédiaire d'absorption vibratoire est composé d'un polymère synthétique comprenant du silicium. De préférence, au moins un plot intermédiaire d'absorption vibratoire est à base de silicone.

Selon un autre mode de réalisation, au moins un plot intermédiaire d'absorption vibratoire est issu d'un procédé de poinçonnage.

### Description des figures

L'invention sera mieux comprise, grâce à la description ci-après, qui se rapporte à des modes de réalisations préférés, donnés à titre d'exemples non limitatifs, et expliqués avec référence aux dessins schématiques annexés, dans lesquels :
- la [Fig. 1] représente une première étape d'un procédé de report d'un MEMS sur un substrat, selon l'invention, consistant à déposer une première couche de matière adhésive à la surface du substrat ;
- la [Fig. 2] représente une deuxième étape du procédé de report selon l'invention, consistant à positionner un plot intermédiaire d'absorption vibratoire sur la première couche de matière adhésive ;
- la [Fig. 3] représente une troisième étape du procédé de report selon l'invention, consistant à déposer une deuxième couche de matière adhésive sur le plot intermédiaire d'absorption vibratoire ;
- la [Fig. 4] représente une quatrième étape du procédé de report selon l'invention, consistant à positionner un MEMS sur la deuxième couche de matière adhésive ;
- la [Fig. 5] représente une première étape de réalisation d'un plot intermédiaire d'absorption vibratoire selon l'invention, par la mise en œuvre d'un procédé de poinçonnage ;
- la [Fig. 6] représente une deuxième du procédé de poinçonnage, consistant à déplacer le poinçon visible sur la figure 5, à travers une matrice pour obtenir un plot intermédiaire d'absorption vibratoire ;
- la [Fig. 7] représente une troisième étape du procédé de poinçonnage, consistant à positionner le poinçon en regard d'une première couche de matière adhésive recouvrant un substrat ;
- la [Fig. 8] représente une quatrième étape du procédé de poinçonnage, consistant à extraire le plot intermédiaire d'absorption vibratoire du poinçon de sorte que ledit plot soit en contact avec la première couche de matière adhésive ;
- la [Fig. 9] représente un graphique sur lequel figure plusieurs simulations de facteur d'amortissement, réalisées à partir de modélisation de dispositifs tests, chaque dispositif test comprenant un MEMS maintenu à un substrat de même nature, par un même procédé de report selon l'invention, les dimensions des plots intermédiaires d'absorption vibratoire maintenant le MEMS à son substrat étant différentes pour chaque dispositif test ;
- la [Fig.10] représente une coupe schématique d'un module MEMS, obtenu à partir d'un procédé de report selon l'invention.

### Description détaillée de l'invention

Pour rappel, l'invention propose un procédé de report d'un MEMS sur un substrat, permettant d'atténuer de façon significative les vibrations du MEMS pour au moins un mode de résonance propre au MEMS.

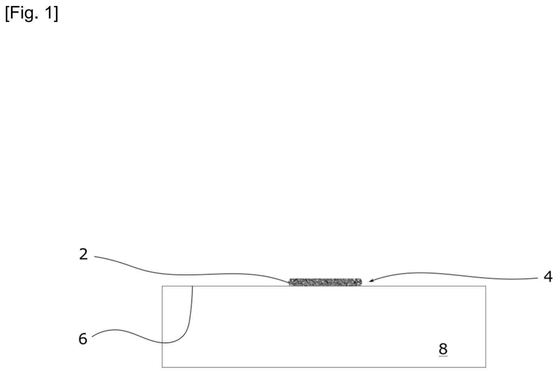

Un mode de réalisation non limitatif d'un procédé de report d'un MEMS sur un substrat, selon l'invention, est illustré par les figures 1 à 4 ci-dessous.

Selon une première étape illustrée par la figure 1, une matière adhésive 2 est déposée sous la forme d'une première couche 4, sur une première face 6 d'un substrat 8. De préférence, la première face 6 du substrat est plane ou sensiblement plane. Le substrat peut être composé d'un matériau métallique et/ou d'un matériau céramique. Dans le cas présent, le substrat 8 est une céramique.

Selon le présent exemple, la matière adhésive 2 est déposée par tamponnage. Cette méthode de dépôt permet avantageusement de former une première couche 4 de matière adhésive de faible épaisseur, sur la première face 6 du substrat. Par « faible épaisseur », on entend une épaisseur comprise entre 1 µm et 10 µm. L'épaisseur de la première couche 4 est mesurée selon une direction normale ou sensiblement normale à la première face 6 du substrat.

Il est à noter qu'afin de faciliter la compréhension de l'invention, les éléments représentés sur les figures ne sont pas à l'échelle.

L'aire de la première face 6 du substrat, recouverte par la première couche 4, est choisie selon les dimensions d'un plot intermédiaire d'absorption vibratoire que l'on souhaite maintenir au substrat 8, comme décrit ci-dessous. La première couche 4 peut par exemple recouvrir une surface de la première face 6 qui est comprise entre 0,05 mm² et 0,2 mm².

La matière adhésive 2 formant la première couche 4 peut être composée d'un polymère synthétique comprenant du silicium, de préférence du silicone.

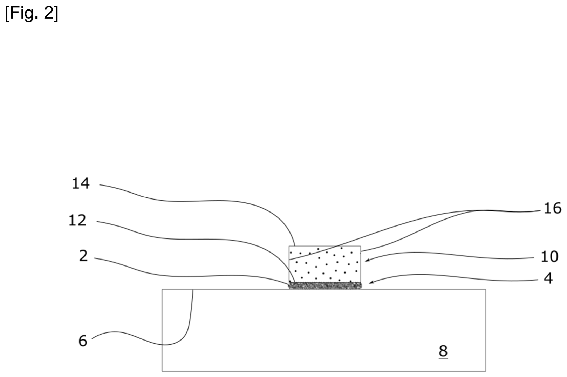

Selon une deuxième étape illustrée par la figure 2, un plot intermédiaire d'absorption vibratoire 10 est superposé à la première couche 4, de sorte qu'une première face 12 dudit plot, nommée également face inférieure, soit en vis-à-vis de la première face 6 du substrat et en contact avec la matière adhésive 2. De préférence, la totalité de la face inférieure du plot intermédiaire d'absorption vibratoire est en contact avec la matière adhésive.

Le plot intermédiaire d'absorption vibratoire 10 est délimité par une deuxième face 14, nommée également face supérieure, opposée à sa face inférieure. De préférence, la face inférieure est plane, la face supérieure est parallèle ou sensiblement parallèle à la face inférieure. La hauteur du plot intermédiaire d'absorption vibratoire, correspondant à la plus petite distance mesurée entre sa face inférieure et sa face supérieure, est égale ou supérieure à 100 µm ou égale ou supérieure à 200 µm, de préférence comprise entre 250 µm et 300 µm ou de l'ordre de 275 µm.

Le plot intermédiaire d'absorption vibratoire se caractérise par un facteur de forme compris entre 0,2 et 1. Par l'expression « facteur de forme », on entend le résultat d'un rapport entre la valeur de la hauteur du plot intermédiaire d'absorption vibratoire et la valeur de sa largeur. La largeur du plot intermédiaire d'absorption vibratoire correspond à la plus petite distance mesurée entre les faces latérales 16 opposées dudit plot et selon une direction parallèle à sa face inférieure 12. La largeur du plot intermédiaire d'absorption vibratoire peut être comprise entre 250 µm et 500 µm.

Selon le présent exemple, le plot 10 est de forme cylindrique et son diamètre est de l'ordre de 500 µm.

Le plot intermédiaire d'absorption vibratoire 10 est composé d'un matériau dont la valeur du module de Young est comprise entre 5 MPa et 10 MPa. La mesure du module de Young est basée sur les mesures des modes de résonance amortis, réalisées à partir de l'instrument commercialisé par la société WATERS sous la référence « ElectroForce 3200 ».

À l'issue de la deuxième étape, le plot intermédiaire d'absorption vibratoire 10 est maintenu par la matière adhésive 2 à la première face 6 du substrat et s'étend perpendiculairement ou sensiblement perpendiculaire à ladite première face 6.

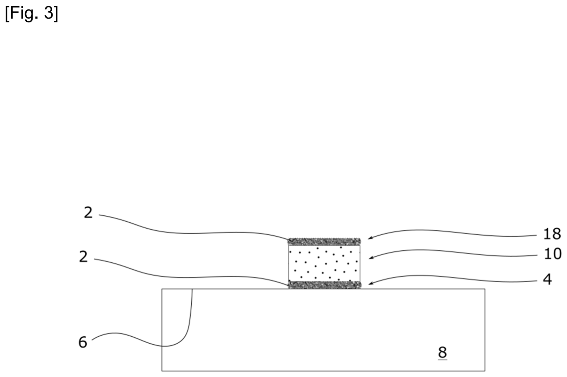

Selon une troisième étape illustrée par la figure 3, une matière adhésive 2 est déposée sur la face supérieure du plot intermédiaire d'absorption vibratoire 10, sous la forme d'une deuxième couche 18. De préférence, la deuxième couche 18 est composée de la même matière ou sensiblement de la même matière que la première couche 4, et la deuxième couche 18 est déposée selon la même méthode que la première couche 4. La deuxième couche 18 est de préférence d'épaisseur identique ou sensiblement identique à la première couche 4 décrite ci-dessus. De préférence, la deuxième couche 18 recouvre l'intégralité de la face supérieure du plot intermédiaire d'absorption vibratoire 10.

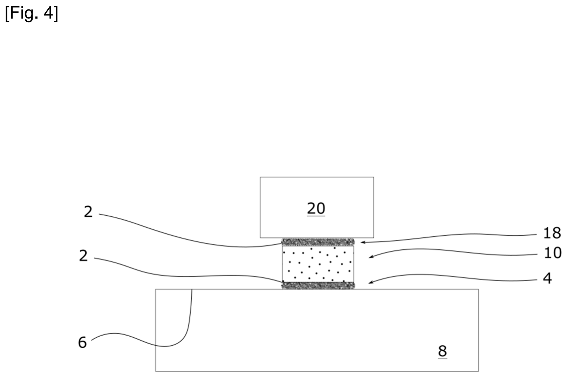

Selon une quatrième étape illustrée par la figure 4, un MEMS 20 est déposé sur la deuxième couche 18, de manière à ce que le MEMS soit supporté par le plot intermédiaire d'absorption vibratoire 10.

Éventuellement, selon une cinquième étape non illustrée, l'ensemble obtenu à l'issue de la quatrième étape, peut être traité thermiquement de manière à favoriser une polymérisation plus rapide et de meilleure qualité de la première couche 4 et de la deuxième couche 18 de matière adhésive. À titre d'exemple non limitatif, le traitement thermique est de l'ordre de 150°C, pendant un laps de temps de l'ordre d'une heure.

De façon avantageuse, le procédé de report selon l'invention permet de maintenir le MEMS 20 à distance de la première face 6 du substrat, avec une quantité de matière adhésive nettement moindre par rapport à l'état de la technique. La présence du plot intermédiaire d'absorption vibratoire 10 entre le substrat 8 et le MEMS 20 permet en effet d'économiser une quantité de matière adhésive non négligeable, habituellement employée pour maintenir une certaine distance entre le MEMS et le substrat.

L'invention permet donc une économie substantielle de matière adhésive lors du report d'un MEMS sur un substrat.

Selon un autre avantage, du fait que la quantité de matière adhésive employée est moindre, les risques de diffusion dans l'environnement de composés issus de la matière adhésive sont significativement réduits. L'invention permet ainsi de minimiser le risque de pollution de l'environnement du MEMS par la matière adhésive.

L'interposition d'un plot intermédiaire d'absorption vibratoire 10 entre le substrat 8 et le MEMS 20 permet avantageusement d'amortir certains modes de vibration du MEMS. De façon avantageuse, les dimensions ainsi que la forme du plot intermédiaire d'absorption vibratoire 10 peuvent être choisies afin d'atténuer ou amortir de façon significative des modes de vibration propre au MEMS.

Par « mode de vibration propre », on entend une vibration du MEMS à une fréquence spécifique à laquelle le MEMS vibre et/ou oscille sous l'effet d'une excitation extérieure .

Le procédé de report selon l'invention est particulièrement avantageux lorsqu'on souhaite minimiser ou du moins atténuer un mode de vibration propre d'un MEMS résonant, susceptible de dégrader ou bien de fausser les mesures réalisées par le MEMS.

Selon une variante de réalisation non représentée du procédé de report décrit ci-dessus, chaque étape peut être reproduite plusieurs fois de manière à ce qu'un MEMS puisse être maintenu à un substrat, par l'intermédiaire de plusieurs plots identiques ou sensiblement identiques au plot intermédiaire d'absorption vibratoire 10.

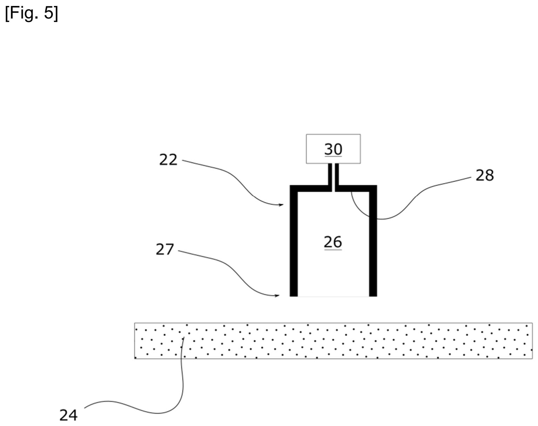

De préférence, le plot intermédiaire d'absorption vibratoire 10 est issu d'un procédé de poinçonnage dont les étapes sont illustrées par les figures 5 à 8 ci-jointes.

La figure 5 illustre une première étape du procédé de poinçonnage selon l'invention, consistant à placer un poinçon 22 en vis-à-vis d'une matrice 24. La matrice 24 est de préférence une couche d'épaisseur identique ou sensiblement identique à la hauteur du plot intermédiaire d'absorption vibratoire 10 décrit ci-dessus.

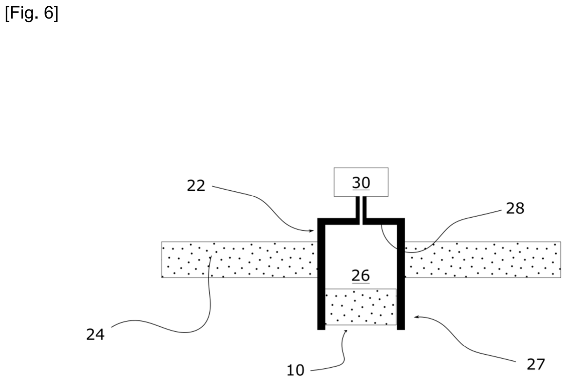

Le poinçon 22 délimite une cavité 26 de forme complémentaire au plot 10 que l'on souhaite obtenir. Selon le présent exemple, la cavité délimite un volume de forme cylindrique. La cavité 26 est ouverte au niveau d'une première extrémité 27 faisant face à la matrice 24. La hauteur de cavité est suffisante pour permettre la réalisation d'une découpe dans la matrice, lors du passage du poinçon 22 à travers la matrice, comme illustré par la figure 6.

À la suite du déplacement du poinçon à travers la matrice 24, un plot 10 est présent dans la cavité 26 du poinçon 22.

De façon avantageuse, le fond 28 de la cavité est connecté à des moyens d'aspiration 30, de manière à assurer le maintien du plot intermédiaire d'absorption vibratoire 10 dans la cavité lors du déplacement du poinçon 22.

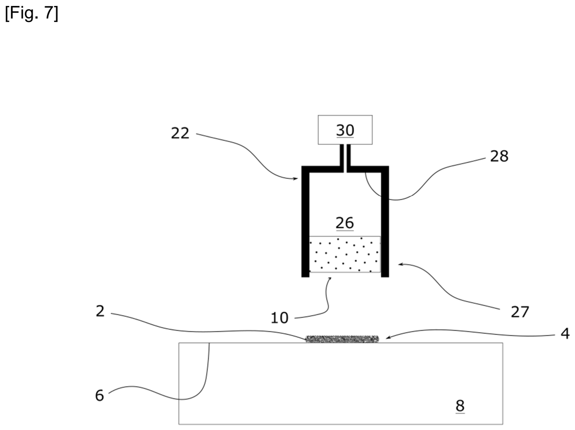

Comme illustré par la figure 7, le poinçon 22 peut être employé pour positionner le plot intermédiaire d'absorption vibratoire 10 en vis-à-vis de la première couche 4 de matière adhésive, lors de la deuxième étape du procédé de report décrit ci-dessus.

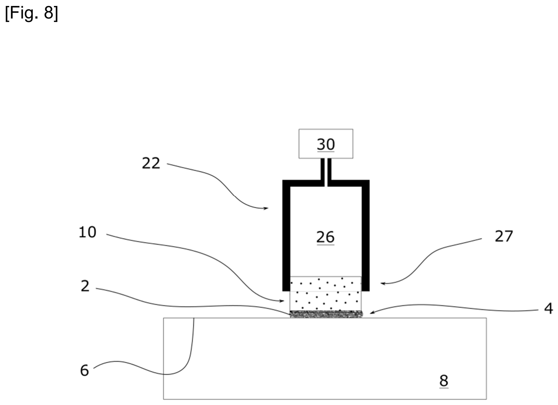

Afin de faciliter l'extraction du plot intermédiaire d'absorption vibratoire 10 de la cavité 26 du poinçon lors du positionnement du plot intermédiaire d'absorption vibratoire 10 sur la première couche 4, les moyens d'aspiration 30 peuvent être déconnectés de la cavité. Selon une variante de réalisation, les moyens d'aspiration 30 peuvent être inversés de sorte à accroître la pression atmosphérique dans le fond de la cavité pour permettre l'expulsion du plot intermédiaire d'absorption vibratoire 10 de ladite cavité, comme illustré par la figure 8.

Le poinçon 22 peut ensuite être écarté du substrat 8 pour pouvoir mettre en œuvre la troisième étape du procédé de report selon l'invention, illustré par la figure 3.

En d'autres termes, le poinçon 22 peut également être employé entant qu'outil pour déplacer et positionner le plot intermédiaire d'absorption vibratoire 10 lors d'un procédé de report d'un MEMS tel que proposé par l'invention.

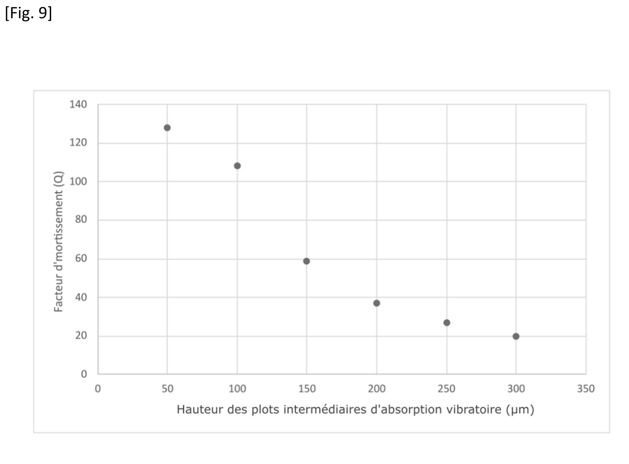

À titre d'exemple non limitatif, le tableau 1 ci-dessous ainsi que la figure 9 ci-jointe, présentent les résultats de simulations par éléments finis : facteurs d'amortissement en fonction de la hauteur des plots intermédiaires d'absorption vibratoire. Le modèle théorique par éléments finis a été validé par des mesures réalisées sur plusieurs dispositifs tests avec des hauteurs des plots intermédiaires d'absorption vibratoire de 100µm et 250µm.

Chaque dispositif test se compose d'un même MEMS maintenu à un même substrat par un même procédé de report tel que décrit-ci-dessus.

**[Table 1]**

| Hauteur des plots intermédiaires d'absorption vibratoire (µm) | Facteur d'amplification (Q) |
|---|---|
| 50 | 128 |
| 100 | 108 |
| 150 | 59 |
| 200 | 37 |
| 250 | 27 |
| 300 | 20 |

Plus précisément, chaque MEMS est maintenu par un même nombre de plots intermédiaires d'absorption vibratoire à son substrat. Les plots intermédiaires d'absorption vibratoire sont de forme identique et agencés de façon semblable entre le MEMS et son substrat.

Les mesures sont réalisées en appliquant au niveau du substrat de chaque dispositif test, par des moyens connus, une vibration mécanique dont la fréquence est égale ou sensiblement égale à la fréquence de résonance du premier mode mécanique du MEMS, dans le cas présent de l'ordre de 2,6 KHz. Le facteur d'amplification (Q) est déterminé en effectuant le rapport entre l'amplitude de vibration observée au niveau de l'élément sensible (à l'intérieur du cadre de découplage qui rentre en résonance), et l'amplitude de vibration appliquée.

Plus précisément, les tests réalisés sont de type spectroscopie, c'est-à-dire qu'une fréquence d'excitation est appliquée à chaque dispositif test, et que ladite fréquence d'excitation est modulée autour d'une fréquence de résonance de l'ordre de 2.6 kHz, de manière à observer une amplification significative de la fréquence de résonance nommée ci-après « pic de résonance ». L'amplitude ainsi que la largeur du pic de résonance permettent de déterminer le facteur d'amplification (Q) tel que décrit ci-dessus.

L'excitation appliquée aux dispositifs a été réalisée en appliquant une excitation mécanique. Pour ce faire, chaque dispositif test est positionné sur un pot vibrant permettant d'appliquer une excitation mécanique dans une plage de fréquences souhaitées, dans le cas présent autour de 2,6 KHz. Les mesures de facteurs d'amortissement sont obtenues à partir de mesures d'accélération au niveau des éléments sensibles du MEMS.

Comme illustré par le tableau 1 et la figure 9, la mise en œuvre de l'invention permet avantageusement de diminuer de façon significative la valeur du facteur d'amplification d'un dispositif test, lorsque la hauteur des plots intermédiaires d'absorption vibratoire maintenant le MEMS à son substrat augmente. L'invention permet ainsi de contrôler précisément la valeur du facteur d'amortissement d'un dispositif test et donc d'un module MEMS, de façon plus précise et plus efficace, pour améliorer la sensibilité des mesures réalisées par le MEMS et également accroître sa longévité.

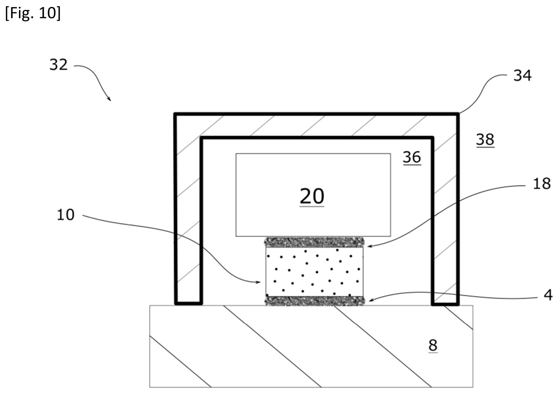

L'invention concerne également un module MEMS 32, tel qu'illustré par la figure 10 ci-jointe. Selon le présent exemple, le module MEMS 32 est obtenu à partir d'un procédé de report décrit ci-dessus.

Le module MEMS 32 se compose ainsi d'un substrat 8 sur lequel est maintenu un MEMS 20, par l'intermédiaire d'au moins un plot intermédiaire d'absorption vibratoire 10 et de couches adhésives 4 et 18 décrites précédemment.

Le module MEMS 32 comprend également un boîtier 34, délimitant une espace creux 36. Le boîtier 34 est maintenu en vis-à-vis du substrat 8, de préférence contre ledit substrat, de sorte que le MEMS soit présent dans l'espace 36 délimité par ledit boîtier.

Le boîtier est de préférence maintenu contre ledit substrat de sorte à protéger le MEMS 20 de l'environnement extérieur 38. Le module MEMS peut être hermétique et/ou étanche à l'environnement extérieur 38.

## Revendications

1. Procédé de report d'un MEMS (20) sur un substrat (8) dans lequel le MEMS (20) est fixé sur le substrat (8), **caractérisé en ce qu'**un plot intermédiaire d'absorption vibratoire (10) est interposé entre le MEMS (20) et le substrat (8), et **en ce que** le plot intermédiaire d'absorption vibratoire (10) présente une hauteur minimum telle que la distance entre le MEMS (20) et le substrat (8) est supérieure à 100 µm.

2. Procédé de report selon la revendication 1, dans lequel le plot intermédiaire d'absorption vibratoire (10) présente une première face (12) en regard du substrat (8) et une deuxième face (14) en regard du MEMS (20), la plus petite dimension de chacune de ces deux faces est égale ou supérieure à 300 µm.

3. Procédé selon la revendication 2, mettant en œuvre les étapes suivantes :
a) dépôt d'une première couche (4) de matière adhésive (2) sur le substrat (8) ; puis
b) dépôt du plot intermédiaire d'absorption vibratoire (10) sur la première couche (4) de matière adhésive (2), la première face (12) du plot intermédiaire d'absorption vibratoire (10) venant en contact avec ladite première couche (4) ; puis
c) dépôt d'une deuxième couche (18) de matière adhésive (2) sur la deuxième face (14) du plot intermédiaire d'absorption vibratoire (10) ; puis
d) mise en contact du MEMS (20) avec la deuxième couche (18) de matière adhésive (2).

4. Procédé de report selon la revendication 2 ou 3, dans lequel la plus petite distance entre la première face (12) et la deuxième face (14) du plot intermédiaire d'absorption vibratoire (10) est égale ou supérieure à 100 µm.

5. Procédé de report selon l'une des revendications 1 à 4, dans lequel la valeur du module de Young du plot intermédiaire d'absorption vibratoire (10) est comprise entre 5 MPa et 10 MPa.

6. Procédé de report selon l'une des revendications 1 à 5, dans lequel le plot intermédiaire d'absorption vibratoire (10) est issu d'un procédé de poinçonnage.

7. Procédé de report selon l'une des revendications 1 à 6, dans lequel le MEMS (20) est de type résonant ou capacitif.

8. Procédé d'encapsulation d'un MEMS (20) mettant en œuvre un procédé de report selon l'une des revendications 1 à 7.

9. Module MEMS (32) comprenant au moins un MEMS (20) encapsulé dans un boîtier (34) et fixé à un substrat (8), **caractérisé en ce qu'**il comporte au moins un plot intermédiaire d'absorption vibratoire (10) interposé entre le MEMS (20) et le substrat (8).

10. Module MEMS (32) selon la revendication 9, dans lequel ledit au moins un plot intermédiaire d'absorption vibratoire (10) présente une hauteur minimum telle que la distance entre le MEMS (20) et le substrat (8) est supérieure à 100 µm.

11. Module MEMS (20) selon la revendication 9 ou 10, dans lequel ledit au moins un plot intermédiaire d'absorption vibratoire (10) présente une première face (12) en regard du substrat (8) et une deuxième face (14) en regard du MEMS (20), la plus petite dimension de chacune de ces deux faces est égale ou supérieure à 300 µm.

12. Module MEMS (20) selon l'une des revendications 9 à 11, dans lequel une première couche (4) de matière adhésive est présente entre le substrat (8) et ledit au moins un plot intermédiaire d'absorption vibratoire (10).

13. Module MEMS (20) selon l'une des revendications 9 à 12, dans lequel la valeur du module de Young dudit au moins un plot intermédiaire d'absorption vibratoire (10), est comprise entre 5 MPa et 10 MPa.

14. Module MEMS (20) selon l'une des revendications 9 à 13, dans lequel ledit au moins un plot intermédiaire d'absorption vibratoire (10) est composé d'un polymère synthétique comprenant du silicium.

15. Module MEMS (20) selon l'une des revendications 9 à 14, dans lequel ledit au moins un plot intermédiaire d'absorption vibratoire (10) est issu d'un procédé de poinçonnage.
